# EUROPÄISCHE PATENTANMELDUNG

(11) **EP 0 602 527 A2**
(43) Veröffentlichungstag der Anmeldung: **22.06.1994**
(21) Anmeldenummer: 93119792.5
(22) Anmeldetag: 08.12.1993
(51) Int. Cl.: H05K 7/08

(54) **Verfahren zur Herstellung von Abstandshalterungen**

(30) Priorität: 17.12.1992 DE 4242825
(71) Anmelder: SIEMENS AKTIENGESELLSCHAFT, D-80333 München (DE)
(72) Erfinder: Külzer, Peter, D-82234 Wessling (DE)

(57) **Zusammenfassung**

Die Erfindung betrifft ein Verfahren zur Herstellung von Abstandshalterungen gleicher Länge für auf gegenüberliegenden Seiten einer Leiterplatte angeordnete Steckverbinder.

Die Montageschienen (5) für die Aufnahme der Steckersockel werden durch Buchsen (1, 2) getragen, die durch die Rückwandleiterplatte (3, 4) gesteckt werden. Durch Stauchen erfolgt ein formschlüssiges Verbinder der Buchsen (1, 2) mit der Leiterplatte (3, 4) und gleichzeitig ein Einstellen eines vorgegebenen Abstandes zwischen den Montageschienen (5).

## Beschreibung

Die Erfindung betrifft ein verfahren zur Herstellung von Abstandshalterungen gleicher Länge für auf gegenüberliegenden Seiten einer Leiterplatte angeordnete Steckverbinder.

An Rückwandleiterplatten von Baugruppenrahmen sind in vielen Fällen beidseitig Steckverbinder angeordnet. Der Abstand der Steckersockel-Befestigungsebenen zueinander muß unabhängig von der Dicke der Rückwandleiterplatte aufgrund der Messerlänge gleich groß sein. Bei der Verwendung von Multilayer-Leiterplatten differiert die Dicke der Leiterplatten erheblich.

Bisher wurde dieses Problem derart gelöst, daß die Steckersockel auf der einen Seite der Leiterplatten direkt befestigt werden und auf der anderen Seite die Stecksockel mittels Montageschienen und Abstandsröhrchen befestigt werden. Dabei müssen unterschiedliche Leiterplattendicken durch verschieden lange Abstandsröhrchen ausgeglichen werden.

Aufgabe der vorliegenden Erfindung ist es, ein Verfahren der eingangs genannten Art anzugeben, welches bei unterschiedlich dicken Leiterplatten auf einfache Art und Weise immer einen gleichen Abstand der Steckersockel-Befestigungsebene zueinander unabhängig von der Dicke der Leiterplatte ermöglicht. Diese Aufgabe wird für ein Verfahren der oben genannten Art dadurch gelöst, daß durch Bohrungen der Leiterplatte gesteckte rohrförmige Abstandsbuchsen mittels eines Stempelwerkzeuges gegen ein auf der gegenüberliegenden Seite der Leiterplatte und in einem zu dieser fest vorgegebenen Abstand angeordneten Dorn auf eine vorgegebene Länge zusammengestaucht werden, wobei das Stempelwerkzeug derart ausgebildet ist, daß es die Buchse im wesentlichen umgreift, wobei in unmittelbarer Nachbarschaft der Leiterplattenoberfläche ein kreisringförmiger Freiraum gebildet wird, der die Ausbildung eines Stauchwulstes zur formschlüssigen Verbindung der Buchse mit der Leiterplatte ermöglicht. Auf diese Weise wird mittels des Dorns ein vorgegebenes Abstandsmaß zwischen der einen Befestigungsebene und der Leiterplatte auf der einen Seite in allen Fällen erreicht. Das vorgegebene Abstandsmaß zwischen den beiden Befestigungsebenen wird aufgrund des Zusammenstauchens der Abstandsbuchsen erreicht. Unabhängig von der Dicke der Leiterplatten wird der Stauchwulst zur formschlüssigen Verbindung der Buchse mit der Leiterplatte immer in unmittelbarer Nachbarschaft der Leiterplattenoberfläche ausgebildet.

Anhand eines in der Zeichnung dargestellten Ausführungsbeispiels soll die Erfindung nachfolgend naher beschrieben werden.

Es zeigen:
- Fig. 1: einen Querschnitt durch eine dünne Leiterplatte mit einer ungestauchten und einer gestauchten Buchse
- Fig. 2: einen Querschnitt durch eine dicke Leiterplatte mit einer ungestauchten und einer gestauchten Buchse,
- Fig. 3: einen teilweisen Schnitt durch eine ungestauchte und eine gestauchte Buchse mit einer Schraube zur Befestigung der gestauchten Buchse, und
- Fig. 4: einen Querschnitt durch eine ungestauchte Buchse.

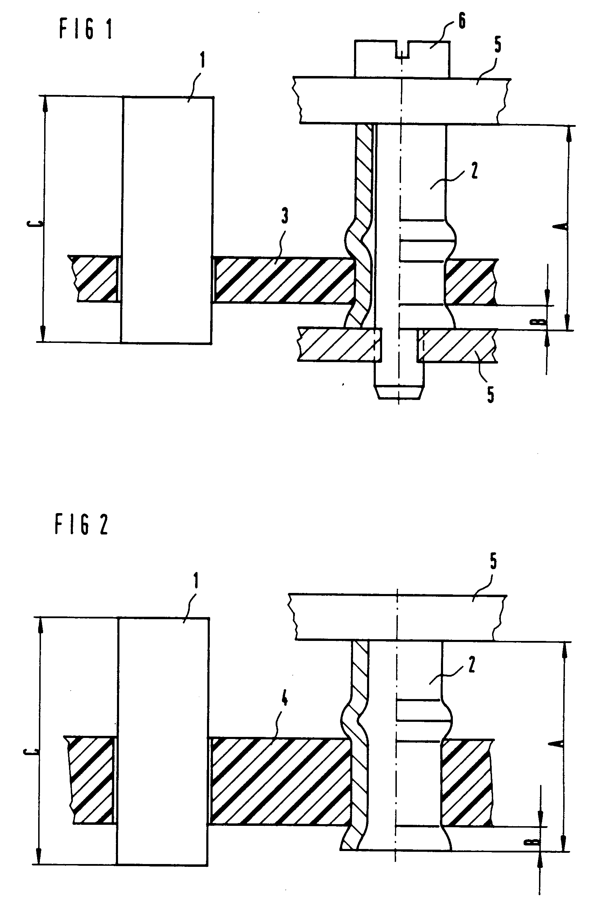

In Figur 1 sind die beiden auf entgegengesetzten Seiten der Leiterplatte 3 angeordneten Montageschienen 5 für die Steckverbinder dargestellt. Zwischen diesen beiden Montageschienen wird ein immer gleiches vorgegebenes Abstandsmaß A verlangt. Die Erfindung geht davon aus, daß auf einer Seite der Leiterplatte das Abstandsmaß B der Befestigungsebene zur Leiterplatte immer fest vorgegeben ist.
Das vorgegebene Abstandsmaß A ist sowohl bei einer dünnen Leiterplatte 3 wie auch bei einer in Figur 2 gezeigten dickeren Leiterplatte 4 immer gleich. Um für die Montageschienen immer den gleichen Abstand zu erhalten, wird durch Bohrungen in den Leiterplatten eine ungestauchte Buchse 1 eingeführt, welche eine Buchsenlänge C aufweist. Mittels eines Stempelwerkzeugs wird diese Buchse gegen ein auf einer vorgegebenen Seite der Leiterplatte und in einem zu dieser fest vorgegebenen Abstand angeordneten Dorn auf eine vorgegebene Länge zusammengestaucht. D.h., daß auf einer Seite der Leiterplatte immer das Abstandsmaß B eingehalten wird. Auf der anderen Seite der Leiterplatte muß die Buchse auf das vorgegebene Abstandsmaß A zusammengestaucht werden. Dies geschieht mittels eines Stempelwerkzeuges, welches die Buchse im wesentlichen umgreift, aber in der unmittelbaren Nachbarschaft der Leiterplattenoberfläche einen kreisringförmigen Freiraum bildet, der beim Stauchvorgang die Ausbildung eines Stauchwulstes ermöglicht, der wiederum die formschlüssige Verbindung der Buchse mit der Leiterplatte ermöglicht.

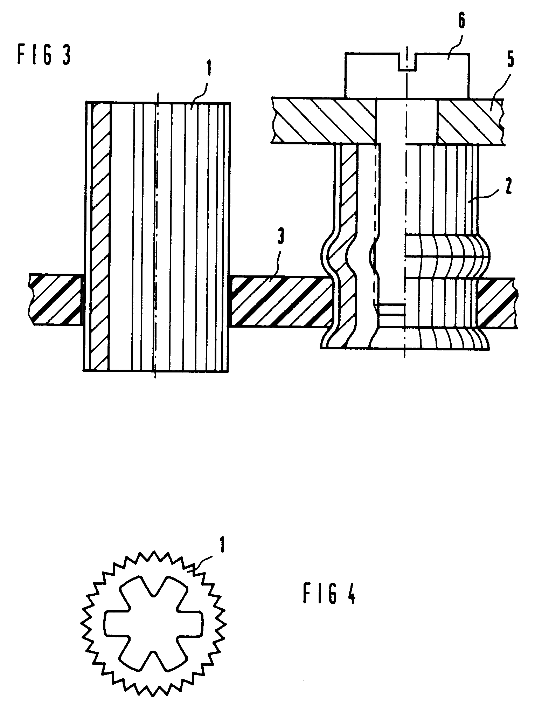

Figur 3 und Figur 4 zeigen detaillierter eine Buchse für selbstschneidende Schrauben 6. Die Formgebung der Bohrung durch die Längsprofilierung verbessert die Verformbarkeit und ermöglicht größere Unterschiede von Innen- zu Außendurchmesser, sowie größere Toleranzunempfindlichkeit des Kerndurchmessers. Die Profilierung am Außendurchmesser dient lediglich zur Drehsicherung.

## Patentansprüche

1. Verfahren zur Herstellung von Abstandshalterungen gleicher Länge für auf gegenüberliegenden Seiten einer Leiterplatte angeordnete Steckverbinder,
**dadurch gekennzeichnet**,
daß durch Bohrungen der Leiterplatte gesteckte rohrförmige Abstandsbuchsen (1) mittels eines Stempelwerkzeugs gegen ein auf der gegenüberliegenden Seite der Leiterplatte (3, 4) und in einem zu dieser fest vorgegebenen Abstand angeordneten Dorn auf eine vorgegebene Länge (A) zusammengestaucht werden, wobei das Stempelwerkzeug derart ausgebildet ist, daß es die Buchse (1) im wesentlichen umgreift, wobei in unmittelbarer Nachbarschaft der Leiterplattenoberfläche (3, 4) ein kreisringförmiger Freiraum gebildet wird, der die Ausbildung eines Stauchwulstes zur formschlüssigen Verbindung der Buchse (1, 2) mit der Leiterplatte (3, 4) ermöglicht.
